# EUROPÄISCHE PATENTSCHRIFT

(11) **EP 2 298 049 B1**
(45) Veröffentlichungstag und Bekanntmachung des Hinweises auf die Patenterteilung: **10.07.2019**
(21) Anmeldenummer: 09772224.3
(22) Anmeldetag: 04.05.2009
(51) Int. Cl.: H05K 5/00, B60R 16/023

(54) **STEUERGERÄT FÜR PERSONENSCHUTZMITTEL FÜR EIN FAHRZEUG**
CONTROL UNIT FOR PERSONAL PROTECTION MEANS FOR A VEHICLE
APPAREIL DE COMMANDE POUR DES MOYENS DE PROTECTION DES OCCUPANTS D'UN VÉHICULE À MOTEUR

(30) Priorität: 03.07.2008 DE 102008040157
(43) Veröffentlichungstag der Anmeldung: 23.03.2011
(73) Patentinhaber: Robert Bosch GmbH, 70442 Stuttgart (DE)
(72) Erfinder: MOSER, Manfred, 72768 Reutlingen (DE); WONNER, Mark, 71672 Marbach Am Neckar (DE); CUPAL, Roland, 71706 Markgroeningen (DE)
(86) Internationale Anmeldenummer: PCT/EP2009/055361
(87) Internationale Veröffentlichungsnummer: WO 2010/000524

(56) Entgegenhaltungen:
- EP-A- 0 650 228
- EP-A- 1 034 983
- EP-A2- 1 282 345
- DE-A1- 10 107 949
- DE-A1- 10 300 767
- DE-U1- 20 012 623
- FR-A1- 2 721 161
- GB-A- 2 167 241
- US-A- 5 428 535
- US-A1- 2001 027 038

## Beschreibung

### Stand der Technik

Die Erfindung betrifft ein System aufweisend ein Steuergerät für Personenschutzmittel für ein Fahrzeug und einen Stecker für den Anschluss eines Kabelbaums an das Steuergerät.

Aus der DE 200 12 623U1 ist bekannt, ein Gehäuse für ein elektrisches Steuergerät, mit einem Bodenteil aus Kunststoff, dass eine metallische Grundplatte aufweist, und einem Deckelteil aus Kunststoff, wobei das Bodenteil eine von der Grundplatte aufragende Stirnwand aufweist, an der ein Steckerkragen angeformt ist, und dass eine Stiftleiste, die eine Vielzahl von Löchern aufweist und in die Löcher eingesetzte Kontaktstifte trägt, die von der Innenseite des Gehäuses her in den Steckerkragen einsetzbar ist.

Aus der EP 1 034 983 A2 ist bekannt, eine Abzweigdose mit einer Vielzahl von Anschluss-Stiften, die fest in eine Gehäuse eingebracht sind, in dem eine Leiterplatte fest untergebracht ist, so dass ein Ende der Anschluss-Stifte aus dem Gehäuse herausragt und das andere Ende der Anschluss-Stifte in das Gehäuse derart hineinragt, dass es fest auf der Leiterplatte gesichert ist. Abstandshalter als Bestandteil des Gehäuses, sind derart angeordnet, dass sie mit der Leiterplatte so in Kontakt stehen, dass eine Verformung der Leiterplatte, beim Anbringen eines Steckers an die Anschluss-Stifte, verhindert wird.

Aus der DE 103 00 767 A1 ist ein elektronisches Gerät umfassend ein Gehäuse, eine erste Anschlusseinheit, die als Steckelementeleiste ausgebildet ist bzw. eine zweite Anschlusseinheit, die Kontaktelemente im Inneren des Gehäuses und eine sich aus dem Gehäuse heraus erstreckende Anschlussleiste aufweist bekannt, wobei das Gehäuse und die erste bzw. die zweite Anschlussleiste derart ausgebildet sind, dass auf die erste bzw. die zweite Anschlusseinheit einwirkende Kräfte unmittelbar auf das Gehäuse übertragen werden.

Aus der US 2001/0027038A1 ist eine Erfindung umfassend eine Gehäuse mit einer Öffnung, elektronische Bauteile und eine in dem Gehäuse installierte Leiterplatte bekannt, wobei ein Steckerkörper an das Gehäuse angebracht ist und ein Verschluss in der Öffnung angeordnet ist.

Aus der US 5,428,535 A ist eine Haupteinheit mit einem Motherboard in einem Gehäuse bekannt. Eine Kontrolleinheit steuert Ausgabegeräte eines Fahrzeugs. Die Kontrolleinheit kann beliebig mit der Haupteinheit verbunden oder von dieser getrennt werden. Die Haupteinheit ist mit Akutatoren über einen Kabelbaum verbunden. Fener ist die Haupteinheit mit Sensoren zur Steuerung der Aktuatoren über den Kabelbaum verbunden. Ein Motherboard der Haupteinheit umfasst gemeinsame Schaltkreise mit den Kontrolleinheiten.

Aus der FR 2 721 161 A1 ist ein elektronisches Modul, das SMI-Technologie mit CMS-Komponenten verwendet bekannt. Die Stecker zur Verbindung mit der äußeren elektrischen Umgebung sind auf einem Sockel mittels Hakeneinrichtungen befestigt, während die Leiterplatten Nasen oder Anschlüsse aufweisen. Zusätzlich umfasst die Erfindung eine Abdeckung in engem Kontakt mit dem Umfang (35) des Sockels und mit dem Körper oder dem Leiterplatte des Verbinders.

Aus EP 0 927 508 B1 ist ein Airbagsteuergerät bekannt, bei dem eine Stiftleiste so angebracht ist, dass ein Stecker an das Steuergerät parallel zur Leiterplattenoberfläche hineingesteckt wird.

### Offenbarung der Erfindung

Das erfindungsgemäße System mit den Merkmalen des unabhängigen Patentanspruchs hat dem gegenüber den Vorteil, dass es einfacher und kostengünstiger hergestellt werden kann. Vorteilhafter Weise wird nämlich ein Kunststoffboden verwendet, um die Leiterplatte zu umschließen. Die Schnittstelle wird vorteilhafter Weise auf der Leiterplatte aufgebracht. Diese Schnittstelle ist dann über eine Öffnung im Kunststoffdeckel für eine elektrische Verbindung mit einem Gegenstecker bereit. D. h. elektrische Signale können über die Schnittstelle auf die Leiterplatte und zu den entsprechenden elektrischen Bauelementen gebracht werden und umgekehrt. Die Schnittstelle kann einfacher als gemäß dem Stand der Technik hergestellt werden, da ein separater Kunststoffkörper für die Schnittstelle eingespart wird.

Vorliegend ist ein Steuergerät für Personenschutzmittel für ein Fahrzeug ein elektrisches Gerät, das Sensorsignale verarbeitet und in Abhängigkeit davon Steuersignale für die Personenschutzmittel erzeugt. Als Sensorsignale werden beispielsweise Beschleunigigungssignale, Körperschallsignale, Drehbewegungssignale wie Drehratensignale, Luftdrucksignale beispielsweise zur Erkennung eines Seitenaufpralls aber auch Fahrdynamiksignale und andere Startersignale verwendet. Die Personenschutzmittel können dabei beispielsweise Airbags, Gurtstraffer bzw. crashaktive Kopfstützen sein. Diese werden im Falle der Ansteuerung d. h. der Aktivierung mit einem Zündstrom bei pyrotechnischen Zündelementen oder einem Aktivierungsstrom bei elektromagnetischen Aktuatoren aktiviert.

Bei der Leiterplatte handelt es sich um eine typische Leiterplatte auf die die elektrischen Bauelemente eingesteckt oder aufgeklebt bzw. aufgelötet werden. Insbesondere die sogenannte und bekannte SMD (Surface Mounted Devices-Technik) führt zu einer besonders kostengünstigen Ausführung. Auf der Leiterplatte sind demnach die elektrischen Bauelemente und Verbindungskontakte zwischen diesen Bauelementen vorhanden.

Der Kunststoffdeckel und der Kunststoffboden bestehen aus einem Kunststoff, der insbesondere die EMV (Elektromagnetische Verträglichkeit) verbessert. Dabei können beispielsweise folgende Materialien verwendet werden: PBT-GF30 und PA66 GF30, wobei der Glasfaseranteil variabel sein kann. Gegebenenfalls kann eine Beimischung für die Verbesserung von elektrischen Abschirmungseigenschaften vorgesehen sein, also eine bessere elektromagnetische Verträglichkeit.

Der Kunststoffdeckel und der Kunststoffboden sind so ausgeführt, dass sie zusammenpassen und dabei die wenigstens eine Leiterplatte mit aufnehmen. In zusammengebautem Zustand ist das Steuergerät tropfwasserfest, sofern der Gegenstecker durch die Öffnung im Kunststoffdeckel auf die Schnittstelle aufgebracht wurde. Die Zusammenbaurichtung ist senkrecht zur Leiterplatte. Die Wasserfestigkeit kann noch durch Dichtungen, die den Gegenstecker im zusammengebauten Zustand umschließen, verbessert werden. Die Dichtungen sind dabei in der Öffnung angebracht.

Die wenigstens eine Schnittstelle ist eine Stiftleiste für die Herstellung einer elektrischen Verbindung mit wenigstens einer weiteren Fahrzeugkomponente beispielsweise über einen Kabelbaum.

Die Öffnung im Kunststoffdeckel weist eine rechteckige oder andere Form auf, um den Gegenstecker möglichst eng zu umfassen.

Durch die in den abhängigen Ansprüchen aufgeführten Maßnahmen und Weiterbildungen sind vorteilhafte Verbesserungen des in den unabhängigen Patentansprüchen angegebenen Steuergeräts bzw. Verfahrens möglich.

Vorteilhaft ist es, dass die wenigstens eine Schnittstelle die elektrische Verbindung in Zusammenbaurichtung ermöglicht. Diese Zusammenbaurichtung ist senkrecht zur Leiterplatte, d. h. die Zusammenbaurichtung durchstößt die Leiterplatte als Ebene. Damit kann die Schnittstelle einfacher ausgeführt werden, da nicht eine elektrische Verbindung über einen Stecker in der Ebene der Leiterplatte stattfindet, wie es aus dem Stand der Technik bekannt ist. Dies ermöglicht insbesondere die günstigere Herstellung des erfindungsgemäßen Steuergeräts.

Weiterhin ist der Kunststoffdeckel derart gestaltet, dass ein Stecker, der in die wenigstens eine Schnittstelle eingeführt wird, mit dem Kunststoffdeckel bündig abschließt. Dieser bündiger Abschluss ermöglicht den besseren Einbau des erfindungsgemäßen Steuergeräts im Fahrzeug und ermöglicht auch einen effektiven Schutz gegen Wasser. Bündiger Abschluss bedeutet dabei, dass die Oberfläche des Kunststoffdeckels in der gleichen Ebene ist wie die Oberseite des Steckers der in die Schnittstelle eingeführt wird. Über den Stecker wird nämlich ein Kabelbaum an das Steuergerät angeschlossen. Die Schnittstelle ist im allgemeinen Sprachgebrauch auch als Kundenschnittstelle bekannt. Über diese Schnittstelle werden beispielsweise die Zündmittel angesteuert. Es werden Daten von Sensoren eingelesen und auch Daten von anderen Steuergeräten wie beispielsweise einem Fahrdynamikregelungssteuergerät.

Vorzugsweise kann für diesen bündigen Abschluss eine Stufe im Kunststoffdeckel vorgesehen sein, wobei die Stufe im Bereich der Stiftleiste konstruiert ist. Durch diese Stufe schließen Gegenstecker und der Gehäusedeckel bündig ab, so dass durch das Anbringen eines sogenannten Showerlabels kein Wasser über die Öffnung in das Steuergerätegehäuse, das durch den Kunststoffdeckel und den Kunststoffboden gebildet wird, eindringen kann.

Das Showerlabel kann mittels einer vorgefertigten Klebefolie realisiert werden, wobei die Klebefolie die Aussenkontur des Gehäuses in geeigneter Form aufnimmt und Tropfwasser weder in den Bereich der Steckverbindung noch der Anschraubungen eindringen kann.

Durch diese Maßnahme wird die Wasserschutzklasse von mindestens IP52 erreicht. Die Gefahr des Eindringens von Tropfwasser in das Steuergerät wird damit vermieden.

Wie oben bereits angedeutet, ist die Schnittstelle als wenigstens eine Stiftleiste ausgeprägt, wobei der Kunststoffdeckel derart ausgebildet ist, dass die wenigstens eine Öffnung und die wenigstens eine Stiftleiste für eine elektrische Verbindung positioniert werden. Dies kann beispielsweise dadurch erreicht werden, dass der Kunststoffdeckel eine Art Trichter aufweist. Die Fixierung dieser Stiftleiste beispielsweise in SMD-Ausführung erfolgt über diese Art von Trichter im Gehäusedeckel, der die Leiterplatte samt Stecker in die richtige Position bringt. Die Steckung des Gegensteckers mit der Schnittstelle im Kunststoffdeckel erfolgt im Gegensatz zum Stand der Technik senkrecht und nicht waagerecht.

Auch weist die Stiftleiste wenigstens zwei Kunststoffpins zum Abfangen von Kräften auf. Diese Kunststoffpins sind beispielsweise in die Leiterplatte eingebracht und führen auch zur Befestigung der Stiftleiste. Die Kräfte sind insbesondere die Kräfte, die beim Anbringen des Gegensteckers in die Schnittstelle im Gehäuse auftreten. Dies führt zu einer erhöhten Zuverlässigkeit des erfindungsgemäßen Steuergeräts.

Vorteilhafter Weise wird der Gegenstecker mit der wenigstens einen Schnittstelle durch eine Steckkontaktierung verbunden. Dies kann, wie oben angegeben, durch die entsprechende Positionierung begünstigt werden.

Die Stiftleiste kann vorteilhafterweise mit einer Durchstecklöttechnik, einer THRS (Through Hole Reflow Soldering) oder einer Einpresstechnik auf der Leiterplatte befestigt sein.

Ausführungsbeispiele der Erfindung sind in der Zeichnung dargestellt und werden in der nachfolgenden Beschreibung näher erläutert.

Es zeigen
- Fig. 1: ein Blockschaltbild des erfindungsgemäßen Steuergeräts mit angeschlossenen Komponenten im Fahrzeug,
- Fig. 2: eine schematische Darstellung der Leiterplatte,
- Fig. 3: eine Seitenschnittansicht des erfindungsgemäßen Steuergeräts,
- Fig. 4: eine weitere Seitenschnittansicht des erfindungsgemäßen Steuergeräts und
- Fig. 5: ein Flußdiagramm des erfindungsgemäßen Verfahrens.

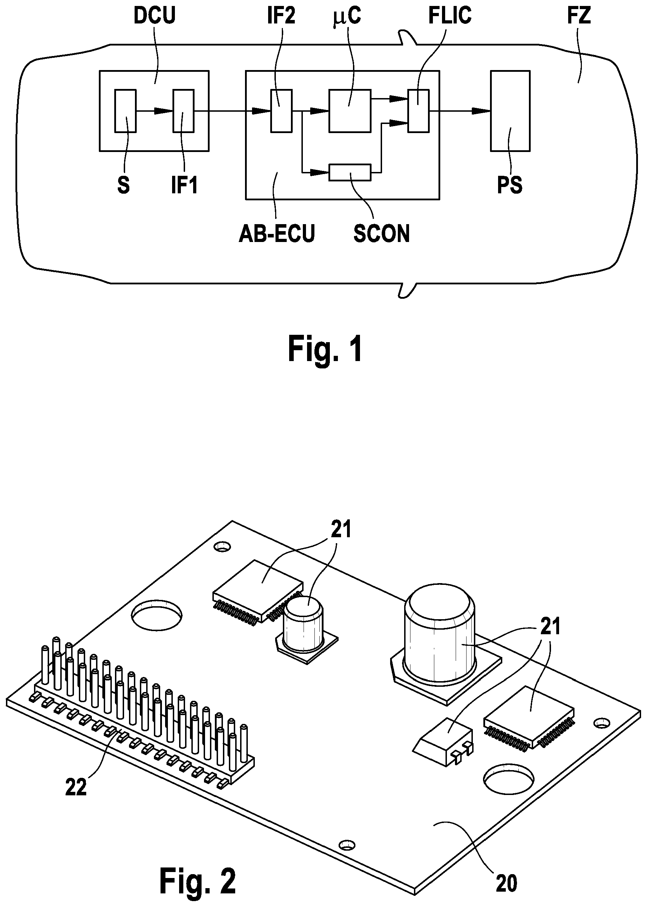

Fig. 1 zeigt in einem Blockschaltbild das erfindungsgemäße Steuergerät mit angeschlossenen Komponenten im Fahrzeug FZ. An das erfindungsgemäße Steuergerät AB-ECU ist ein Sensorsteuergerät DCU angeschlossen, dass eine Sensorik S, beispielsweise eine Drehraten- und/oder Drehbewegungssensorik aufweist, die ihre Daten über eine erste Schnittstelle IF1 an das Airbagsteuergerät AB-ECU überträgt. Bei der Schnittstelle kann es sich um eine Busschnittstelle oder eine Punkt-zu-Punkt-Verbindung handeln. Die Daten werden im Airbagsteuergerät AB-ECU von einer zweiten Schnittstelle IF2 empfangen und in ein Steuergerät des internes Format, beispielsweise SPI (Serial Peripherial Interface) umgewandelt. Dabei werden die Sensordaten sowohl der Auswerteschaltung nämlich einen Mikrocontroller µC als auch einem sogenannten Safety Controller SCON zugeführt, so dass zwei unabhängige Auswertepfade für die Auswertung der Sensordaten vorliegen. Nur wenn beide Auswertungen ergeben, dass die Personenschutzmittel PS wie Airbags anzusteuern sind, steuert die Ansteuerschaltung FLIC die die Auswerteergebnisse bzw. Ansteuersignale des Mikrocontrollers µC bzw. des Safety Controllers SCON erhält, die Personenschutzmittel an.

Dabei werden beispielsweise Zündelemente mit einem Zündstrom beaufschlagt.

Diese funktionelle Grundstruktur kann variiert werden, beispielsweise können Sensoren auch im Airbagsteuergerät ABECU angeordnet sein. Es können noch weitere Daten von anderen Steuergeräten beispielsweise über einen CAN-Transceiver in der Auswertung berücksichtigt werden. Bei den Auswertealgorithmen wird das Signal, beispielsweise ein Beschleunigungssignal üblicher Weise rechentechnisch pragmatisch integriert und mit variablen oder festen Schwellwerten verglichen, um zu einer Ansteuerungsentscheidung zu kommen. Bei einem variablen Schwellwert ist es insbesondere vorteilhaft, den Schwellwert auf das Beschleunigungssignal beispielsweise selbst zu adaptieren. Der Safety Controller SCON ist üblicher Weise einfacher ausgebildet als der Mikrontroler µC. Es sind jedoch auch genau solche komplexen Strukturen als Safety Controller wie ein Mikrocontroller möglich. Üblicher Weise weist der Safety Controller daher Schwellwertauswertungen auf, die üblicher Weise feste Schwellwerte aufweisen und daher sind diese Auswertungen nicht so genau wie die eines komplexeren Softwareprogramms.

Die Ansteuerschaltung FLIC weist entsprechende Auswerteelektronik auf um die Ansteuersignale des Mikrocontrollers µC und des Safety Controllers SCON auswerten zu können. Vorliegend sind nur für das Verständnis der Erfindung notwendigen Bauelemente dargestellt. Für den Betrieb des Steuergeräts ABECU sind noch weitere Bauelemente notwendig.

Das Airbagsteuergerät wird üblicher Weise im Bereich des Fahrzeugtunnels eingebaut. Weist es jedoch keine Sensoren auf, ist es möglich es auch an anderen Orten einzubauen. Dabei ist nur darauf zu achten, dass im Falle eines Unfalls dieses Airbagsteuergerät allenfalls in einer späten Phase des Unfalls zerstört wird.

Fig. 2 zeigt eine Ansicht einer Leiterplatte 20, wie sie erfindungsgemäß verwendet werden kann. Die Leiterplatte 20, die insbesondere für SMD-Bauteile konfiguriert ist und daher lediglich Bohrungen für die Befestigung der Leiterplatte bzw. Fixierung am Kunststoffboden bzw. in Verbindung mit dem Kunststoffdeckel aufweist nimmt verschiedene elektrische Bauelemente 21 auf und die Stiftleiste 22, die die Verbindung mit der Schnittstelle im Kunststoffdeckel herstellt. Die Bauelemente 21 und auch die Stiftleiste 22 werden beispielsweise durch einen sogenannten Reflowprozess auf der Leiterplatte fixiert und damit festgelötet. Die Stiftleiste 22 ist vorliegend in SMD-Technik ausgebildet. D. h. sie kann platzsparend ohne großen Kunststoffkörper ausgeführt sein.

Die Stiftleiste kann mittels Durchstecklöttechnik, THRS (Through Hole Reflow Soldering) oder Einpresstechnik ausgeführt sein.

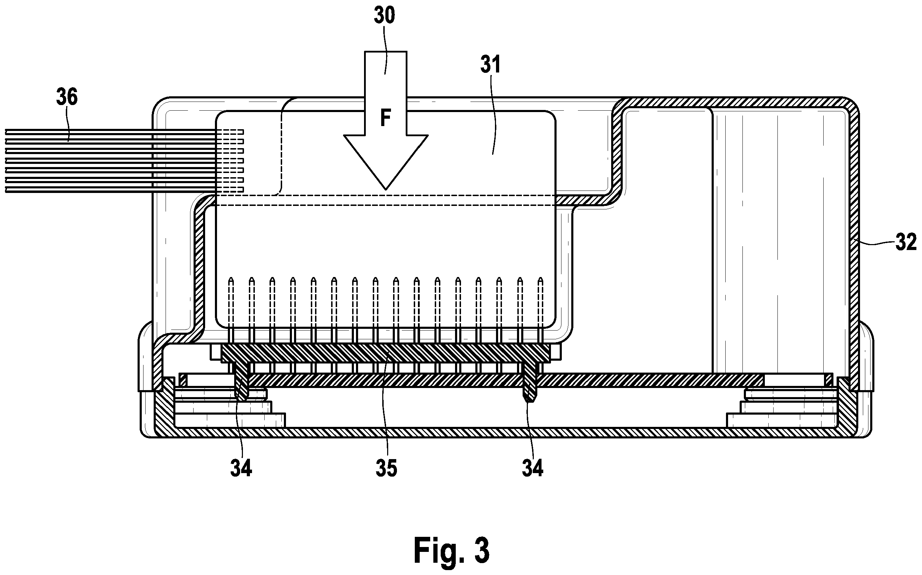

Fig. 3 zeigt in einer Seitenschnittansicht das erfindungsgemäße Steuergerät mit seinem Gehäuse 32 und den Gegenstecker 31, der den Kabelbaum 36 mit der Schnittstelle auf der Leiterplatte durch die Öffnung im Kunststoffdeckel verbindet. Die Steckrichtung und die Kraftrichtung sind senkrecht auf die Leiterplatte gerichtet, wie es im Fall 30 gezeigt wird. Die Stiftleiste 35 als der Schnittstelle weist Kunststoffpins 34 auf, die zum Abfangen der Kräfte des Gegensteckers vorgesehen sind. Alleine die Möglichkeit die Steckrichtung nicht waagerecht, sondern wie vorliegend senkrecht vornehmen zu können, führt zu erheblichen Kosteneinsparungen.

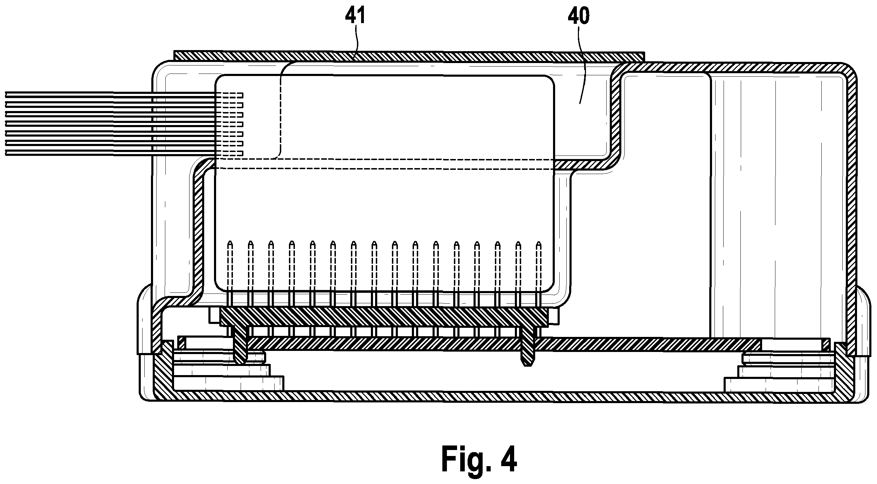

Fig. 4 zeigt eine weitere Seitenschnittansicht des erfindungsgemäßen Steuergeräts. Durch die Integration der Stiftleiste im Gehäuse, d. h. die Schnittstelle ist im Gehäuse und die senkrechte Steckung des Gegensteckers besteht die Gefahr des Eindringens von Tropfwasser in das Steuergerät. Um eine Wasserschutzklasse von mindestens IP52 zu erreichen, wurde das Gehäuse mit einer Stufe im Bereich der Stiftleiste konstruiert. Diese Stufe schließen Gegenstecker und der Gehäusedeckel bündig ab, so dass durch das Eindringen eines Showerlabels kein Wasser über die Öffnung in das Gehäuse eindringen kann. Mit Bezugszeichen 41 ist das Showerlabel bezeichnet und mit Bezugszeichen 40 die Stufe im Gehäusedeckel.

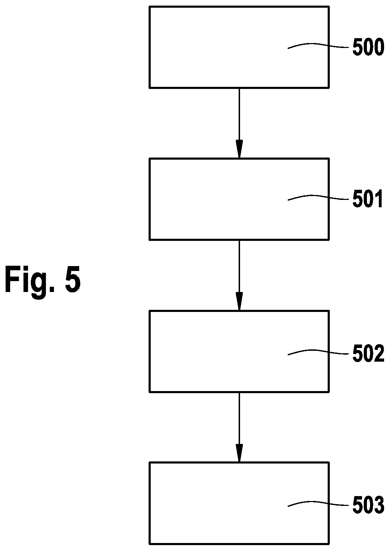

Fig. 5 zeigt in einem Flußdiagramm den Ablauf eines Verfahrens. Zunächst werden in Verfahrensschritt 500 elektrische Bauelemente auf der Leiterplatte angeordnet, bspw. durch Auflöten oder Aufkleben befestigt.

In Verfahrensschritt 501 erfolgt die Anordnung der Schnittstelle mithin der Stiftleiste ebenfalls auf der Leiterplatte durch Auflöten oder Aufkleben.

In Verfahrensschritt 502 wird eine Öffnung, durch die der Gegenstecker auf die Stiftleiste aufgesteckt wird, in dem Kunststoffdeckel vorgesehen. Dies kann im Spritzguß- oder einem anderen Herstellungsverfahren für den Kunststoffdeckel schon so vorgesehen sein.

In Verfahrensschritt 503 wird die bestückte Leiterplatte zwischen dem Kunststoffdeckel und dem Kunststoffboden angeordnent. Die Befestigung gelingt bspw. zunächst über kraft- oder formschlüssige Verbindungsmittel.

## Patentansprüche

1. System aufweisend ein Steuergerät (AB-ECU) für Personenschutzmittel (PS) für ein Fahrzeug (FZ) und einen Stecker (31) für den Anschluss eines Kabelbaums an das Steuergerät (AB-ECU), wobei das Steuergerät (AB-ECU) umfasst:
- wenigstens eine Leiterplatte (20) für eine Aufnahme von elektrischen Bauelementen (21);
- einen Kunststoffdeckel (32) und einen Kunststoffboden, zwischen denen die wenigstens eine Leiterplatte (20) angeordnet ist;
- wenigstens eine Schnittstelle (22, 35) für eine elektrische Verbindung mit mindestens einer weiteren Fahrzeugkomponente, wobei die wenigstens eine Schnittstelle (22, 35) auf der wenigstens einen Leiterplatte (20) vorgesehen ist und der Kunststoffdeckel (32) wenigstens eine Öffnung für die Herstellung der elektrischen Verbindung aufweist, wobei die Schnittstelle (22, 35) als wenigstens eine Stiftleiste (22, 35) ausgebildet ist, wobei die Stiftleiste (22, 35) wenigstens zwei Kunststoffpins (34) zum Abfangen von Kräften (F) aufweist, wobei
der Kunststoffdeckel (32) so ausgebildet ist, dass die wenigstens eine Öffnung und die wenigstens eine Stiftleiste (22, 35) für eine elektrische Verbindung positioniert werden, wobei die Öffnung derart gestaltet ist, dass der Stecker (31) auf die Stiftleiste (22, 35) zur Herstellung der elektrischen Verbindung aufgesteckt ist, wobei die Steckrichtung und die Kraftrichtung senkrecht auf die Leiterplatte (20) gerichtet sind, wobei der Kunststoffdeckel (32) derart gestaltet ist, dass der Stecker (31), der in die wenigstens eine Öffnung eingeführt wird, mit dem Kunststoffdeckel (32) bündig abschließt, sodass die Oberfläche des Kunststoffdeckels (32) in der gleichen Ebene ist wie die Oberseite des Steckers (31).

2. System nach Anspruch 1, **dadurch gekennzeichnet, dass** der Kunststoffdeckel (32) eine Stufe (40) aufweist, damit die Oberseite des Steckers (31) und die Oberseite des Kunststoffdeckels (32) in einer Ebene liegen, wenn der Stecker (31) in die wenigstens eine Öffnung eingeführt ist.

3. System nach Anspruch 1, **dadurch gekennzeichnet, dass** die Ausbildung des Kunststoffdeckels (32) ein Trichter ist.

4. System nach Anspruch 1 oder 3, **dadurch gekennzeichnet, dass** die Stiftleiste (22, 35) mittels Durchstecklöttechnik, Through Hole Reflow Soldering oder Einpresstechnik befestigt ist.

5. System nach einem der Ansprüche 1, 3 oder 4, **dadurch gekennzeichnet, dass** mittels einer vorgefertigten Klebefolie (41) ein Schutz gegen in das Gehäuse eindringendes Wasser realisiert ist, wobei die Klebefolie (41) die Außenkontur des aus dem Kunststoffdeckel (32) und dem Kunststoffboden gebildeten Gehäuses annimmt.

## Claims

1. System having a control unit (AB-ECU) for personal protection means (PS) for a vehicle (FZ) and having a plug (31) for the connection of a cable harness to the control unit (AB-ECU), wherein the control unit (AB-ECU) comprises:
- at least one printed circuit board (20) for receiving electrical components (21);
- a plastic cover (32) and a plastic base between which the at least one printed circuit board (20) is arranged;
- at least one interface (22, 35) for an electrical connection to at least one further vehicle component, wherein the at least one interface (22, 35) is provided on the at least one printed circuit board (20) and the plastic cover (32) has at least one opening for establishing the electrical connection, wherein the interface (22, 35) is designed as at least one male strip connector (22, 35), wherein the male strip connector (22, 35) has at least two plastic pins (34) for absorbing forces (F), wherein the plastic cover (32) is designed such that the at least one opening and the at least one male strip connector (22, 35) are positioned for electrical connection, wherein the opening is configured in such a way that the plug (31) is fitted onto the male strip connector (22, 35) for establishing the electrical connection, wherein the insertion direction and the force direction are directed perpendicularly on the printed circuit board (20), wherein the plastic cover (32) is configured in such a way that the plug (31), which is introduced into the at least one opening, terminates flush with the plastic cover (32), so that the surface of the plastic cover (32) is in the same plane as the top side of the plug (31).

2. System according to Claim 1, **characterized in that** the plastic cover (32) has a step (40), so that the top side of the plug (31) and the top side of the plastic cover (32) lie in one plane when the plug (31) is introduced into the at least one opening.

3. System according to Claim 1, **characterized in that** the plastic cover (32) is designed as a funnel.

4. System according to Claim 1 or 3, **characterized in that** the male strip connector (22, 35) is fastened by means of through-hole soldering technology, through-hole reflow soldering or press-fitting technology.

5. System according to one of Claims 1, 3 and 4, **characterized in that** protection against the ingress of water into the housing is realized by means of a prefabricated adhesive film (41), wherein the adhesive film (41) adopts the outer contour of the housing which is formed from the plastic cover (32) and the plastic base.

## Revendications

1. Système comprenant un appareil de commande (AB-ECU) destiné à des moyens de protection d'occupants (PS) d'un véhicule (FZ) et une fiche (31) pour le raccordement d'un harnais de câbles à l'appareil de commande (AB-ECU), dans lequel l'appareil de commande comprend (AB-ECU) :
- au moins une carte de circuit imprimé (20) destinée à recevoir des composants électriques (21) ;
- un couvercle en matière plastique (32) et un fond en matière plastique, entre lesquels est disposée ladite au moins une carte de circuit imprimé (20) ;
- au moins une interface (22, 35) destinée à un raccordement électrique à au moins un autre composant du véhicule, dans lequel ladite au moins une interface (22, 35) est prévue sur ladite au moins une carte de circuit imprimé (20) et le couvercle en matière plastique (32) présente au moins une ouverture pour effectuer le raccordement électrique, dans lequel l'interface (22, 35) est réalisée sous la forme d'au moins une barrette de broches (22, 35), dans lequel la barrette de broches (22, 35) présente au moins deux broches en matière plastique (34) destinées à absorber des forces (F), dans lequel le couvercle en matière plastique (32) est réalisé de telle manière que ladite au moins une ouverture et ladite au moins une barrette de broches (22, 35) soient positionnées en vue d'un raccordement électrique, dans lequel l'ouverture est réalisée de telle manière que la fiche (31) soit enfichée sur la barrette de broches (22, 35) pour réaliser le raccordement électrique, dans lequel la direction d'enfichage et la direction de la force sont orientées perpendiculairement à la carte de circuit imprimé (20), dans lequel
le couvercle en matière plastique (32) est conçu de telle manière que la fiche (31) qui est insérée dans ladite au moins une ouverture affleure par rapport au couvercle en matière plastique (32) afin que la surface du couvercle en matière plastique (32) soit dans le même plan que la face supérieure de la fiche (31).

2. Système selon la revendication 1, **caractérisé en ce que** le couvercle en matière plastique (32) présente un gradin (40) pour que la face supérieure de la fiche (31) et la face supérieure du couvercle en matière plastique (32) reposent dans un plan lorsque la fiche (31) est introduite dans ladite au moins une ouverture.

3. Système selon la revendication 1, **caractérisé en ce que** le couvercle en matière plastique (32) est réalisé sous la forme d'un entonnoir.

4. Système selon la revendication 1 ou 3, **caractérisé en ce que** la barrette de broches (22, 35) est fixée au moyen d'une soudure par trous traversants, par soudure du type Through Hole Reflow Soldering ou par une technique de pressage.

5. Système selon l'une des revendications 1, 3 ou 4, **caractérisé en ce qu'**une protection contre la pénétration d'eau dans le boîtier est réalisée au moyen d'un film adhésif préfabriqué (41), dans lequel le film adhésif (41) s'adapte au contour extérieur du boîtier formé par le couvercle en matière plastique (32) et le fond en matière plastique.
